# EUROPEAN PATENT APPLICATION

(11) **EP 2 669 961 A2**
(43) Date of publication of application: **04.12.2013**
(21) Application number: 13169634.6
(22) Date of filing: 29.05.2013
(51) Int. Cl.: H01L 33/00, H01L 33/46, H01L 33/62

(54) **Method of manufacturing thin-film bonded substrate used for semiconductor device**

(30) Priority: 29.05.2012 KR 20120056459
(71) Applicant: Samsung Corning Precision Materials Co., Ltd., Gyeongsangbuk-do Gumi-si, 730-735 (KR)
(72) Inventor: Kim, Donghyun, 336-841 Asan-si ChungCheongNam-Do (KR); Kim, Dong-Woon, 336-841 Asan-si ChungCheongNam-Do (KR); Kim, Mikyoung, 336-841 Asan-si ChungCheongNam-Do (KR); Kim, MinJu, 336-841 Asan-si ChungCheongNam-Do (KR); Kim, A-Ra, 336-841 Asan-si ChungCheongNam-Do (KR); Kim, Hyunjoon, 336-841 Asan-si ChungCheongNam-Do (KR); Shur, Joong Won, 336-841 Asan-si ChungCheongNam-Do (KR); Woo, Kwang-Je, 336-841 Asan-si ChungCheongNam-Do (KR); Lee, Bohyun, 336-841 Asan-si ChungCheongNam-Do (KR); Jeon, Jongpil, 336-841 Asan-si ChungCheongNam-Do (KR); Jung, Kyungsub, 336-841 Asan-si ChungCheongNam-Do (KR)
(74) Representative: Gulde Hengelhaupt Ziebig & Schneider

(57) **Abstract**

A method of manufacturing a thin-film bonded substrate used for semiconductor devices. The method includes the steps of epitaxially growing an epitaxial growth layer on a first substrate of a bulk crystal, cleaving the first substrate, thereby leaving a crystal thin film on the epitaxial growth layer, the crystal thin film being separated out of the first substrate, and bonding a second substrate to the crystal thin film, the chemical composition of the second substrate being different from the chemical composition of the first substrate. It is possible to preclude a conductive barrier layer of the related art, prevent a reflective layer from malfunctioning due to high-temperature processing, and essentially prevent cracks due to the difference in the coefficients of thermal expansion between heterogeneous materials that are bonded to each other.

## Description

### CROSS REFERENCE TO RELATED APPLICATION

The present application claims priority from Korean Patent Application Number 10-2012-0056459 filed on May 29, 2012, the entire contents of which application are incorporated herein for all purposes by this reference.

### BACKGROUND OF THE INVENTION

### Field of the Invention

The present invention relates to a method of manufacturing a thin-film bonded substrate used for semiconductor devices, and more particularly, to a method of manufacturing a thin-film bonded substrate used for semiconductor devices, which can preclude a conductive barrier layer of the related art, prevent a reflective layer from malfunctioning due to high-temperature processing, and essentially prevent cracks due to the difference in the coefficients of thermal expansion between heterogeneous materials that are bonded to each other.

### Description of Related Art

The performance and lifespan of a semiconductor device, such as a laser diode or a light-emitting diode (LED), are determined by a variety of components that constitute the corresponding device, in particular, by a base substrate on which devices are stacked. Accordingly, several methods for manufacturing high-quality semiconductor substrates are being proposed, and interest in group III-V compound semiconductor substrates is increasing.

Here, gallium nitride (GaN) substrates can be regarded as a representative example of group III-V compound semiconductor substrates. While GaN substrates are suitable for semiconductor devices together with gallium arsenide (GaAs) substrates, indium phosphide (InP) substrates, and the like, the manufacturing cost thereof is much more expensive than those of GaAs substrates and InP substrates. Accordingly, the manufacturing cost of semiconductor devices which adopt GaN substrates becomes very high. This originates from differences in manufacturing methods of GaN substrates, GaAs substrates and InP substrates.

Specifically, as for GaAs substrates and InP substrates, the growth rate of the crystal is rapid since crystalline growth is carried out by a liquid method, such as the Bridgman method or the Czochralski method. It is therefore possible to easily produce a large GaAs or InP crystalline bulk having a thickness of 200nm or greater in a crystal growth time of, for example, about 100 hours. Accordingly, a large number of, for example, 100 or more GaAs or InP substrates having a thickness ranging from 200 µm to 400 µm can be cleaved from the large GaAs or InP crystalline bulk.

In contrast, as for GaN substrates, the growth rate of crystal is slow since crystalline growth is carried out by a vapor deposition method, such as hydride vapor phase epitaxy (HVPE) or metal organic chemical vapor deposition (MOCVD). In an example, a GaN crystalline bulk can be produced with a thickness of only about 10 mm for a crystal growth time of 100 hours. When the thickness of the crystal is in that range, only a small number of, for example, 10 GaN substrates having a thickness ranging from 200 µm to 400 µm can be divided from that crystal.

However, when the thickness of a GaN film to be cleaved from the GaN crystalline bulk is reduced in order to increase the number of cleaved GaN substrates, the mechanical strength of the cleaved substrates decreases to the extent that the cleaved substrates cannot create a self-supporting substrate. Therefore, a method for reinforcing the strength of a GaN thin film layer that is cleaved from the GaN crystalline bulk was required.

As the method for reinforcing a GaN thin film layer of the related art, there is a method of manufacturing a substrate (hereinafter, referred to as a bonded substrate) in which a GaN thin film layer is bonded to a heterogeneous substrate which has a different chemical composition from GaN.

As for vertical LED structures which are used for high-luminance and high-efficiency applications, the entire body of a vertical LED must be conductive since current flows in the vertical direction, i.e. the top-bottom direction, of the LED. In addition, in order to improve the light efficiency of a vertical LED, it is required to extract 90% or more of blue wavelength light generated by a light source by forming a reflective layer inside the LED.

In order to use a GaN/Si bonded substrate to which the layer transfer technique is applied as a substrate for these vertical LEDs, a reflective layer must be formed between a GaN thin film and a Si substrate. In addition, the process of growing an epitaxial growth layer of a vertical LED on the GaN/Si bonded substrate is carried out using MOCVD equipment at a process temperature of 1000 °C in a hydrogen atmosphere. However, GaN is decomposed into Ga and N at 1000 °C, leading to the precipitation of Ga metal. The precipitated Ga metal destroys the Si substrate via melt-back etching on Si. In addition, since the coefficient of thermal expansion of GaN is twice that of Si, the GaN/Si bonded substrate which is directly bonded at 200 °C is vulnerable to cracks due to the difference in the coefficients of thermal expansion while being cooled down to room temperature after epitaxial growth processing.

In the related art, in order to complement for this, a barrier material which reduces a reaction between Ga and Si is deposited on the Si substrate. Here, the barrier material is required to be conductive considering the characteristics of the vertical LED and satisfy complicated requirement of being able to properly operate at a high temperature of 1000 °C. This is the same as for the above-described reflective layer. This requires the use of an expensive material in order to satisfy that requirement, thereby causing the problem of the increased manufacturing cost.

The information disclosed in the Background of the Invention section is only for better understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a method of manufacturing a thin-film bonded substrate used for semiconductor devices, which can preclude a conductive barrier layer of the related art, prevent a reflective layer from malfunctioning due to high-temperature processing, and essentially prevent cracks due to the difference in the coefficients of thermal expansion between heterogeneous materials that are bonded to each other.

In an aspect of the present invention, provided is a method of manufacturing a thin-film bonded substrate used for a semiconductor device. The method includes the following steps of: epitaxially growing an epitaxial growth layer on a first substrate of a bulk crystal; cleaving the first substrate, thereby leaving a crystal thin film on the epitaxial growth layer, the crystal thin film being separated out of the first substrate; and bonding a second substrate to the crystal thin film, the chemical composition of the second substrate being different from the chemical composition of the first substrate.

According to an exemplary embodiment of the invention, the step of cleaving the first substrate may include bonding a third substrate to the epitaxial growth layer before cleaving the first substrate.

In another aspect of the present invention, provided is a method of manufacturing a thin-film bonded substrate used for a semiconductor device. The method includes the following steps of: epitaxially growing an epitaxial growth layer on a first substrate of a bulk crystal; implanting ions into the first substrate to a predetermined depth from one surface of the first substrate which adjoins one surface of the epitaxial growth layer, thereby forming an ion implantation layer in the first substrate; bonding a third substrate to the other surface of the epitaxial growth layer; cleaving the first substrate along the ion implantation layer, thereby leaving the crystal thin film on the one surface of the epitaxial growth layer, the crystal thin film being separated out of the first substrate; bonding a second substrate to the crystal thin film, the chemical composition of the second substrate being different from the chemical composition of the first substrate; and removing the third substrate.

The crystalline bulk may be made of a nitride semiconductor material.

The step of epitaxially growing the epitaxial growth layer may include growing the epitaxial growth layer in a stacked structure which has a multi-quantum well layer and a p-cladding layer stacked on the multi-quantum well layer.

The p-cladding layer may be made of a nitride semiconductor material.

The crystal thin film may form an n-cladding layer.

The step of implanting the ions may include forming the ion implantation layer at a thickness ranging from 0.1 µm to 100 µm from the one surface of the first substrate.

The ions may be ions of one selected from the group consisting of hydrogen, helium and nitrogen.

The step of bonding the third substrate may include bonding the third substrate to the other surface of the epitaxial growth layer via an adhesive.

The step of bonding the third substrate may include directly bonding the third substrate to the other surface of the epitaxial growth layer via heating and pressing.

The step of cleaving the first substrate may include heat-treating the ion implantation layer.

The step of cleaving the first substrate may include cutting the ion implantation layer.

The method may further include the step of, before bonding the second substrate to the crystal thin film, depositing a reflective layer on one surface of the second substrate to which the crystal thin film is to be bonded.

According to embodiments of the invention, unlike the process of forming an epitaxial growth layer at a high temperature after bonding a bulk crystal and a heterogeneous substrate to each other in the related art, the layer transfer processing is carried out after the preceding process of growing the epitaxial growth layer on one surface of the bulk crystal. It is therefore possible to reduce a reaction between the heterogeneous materials which are bonded to each other and preclude a barrier layer that was formed in order to complement for the difference in the coefficients of thermal expansion between the heterogeneous materials. It is also possible to use reflective materials based on common inexpensive metals which were impossible to use because their reflective function was deteriorated at the high-temperature processing in the related art, thereby reducing the manufacturing cost. Since the high-temperature processing does not follow the layer transfer processing, it is possible to fundamentally prevent cracks due to the difference in the coefficients of thermal expansion between the heterogeneous substrates.

In addition, since the process of forming the epitaxial growth layer for vertical LEDs is included, it is possible to simplify a fabrication process for vertical LEDs compared to the related art in which the epitaxial growth layer is formed after the substrate bonding process.

In another aspect of the present invention, provided is a thin-film bonded substrate obtainable by a method according to the present invention.

In another aspect of the present invention, a laser diode comprising the thin-film bonded substrate obtainable by a method according to the present invention is disclosed. In another aspect of the present invention, a light-emitting diode comprising the thin-film bonded substrate obtainable by a method according to the present invention is disclosed.

In another aspect of the present invention, a method for manufacturing a laser diode is disclosed, the method comprising the method of manufacturing a thin-film bonded substrate according to the present invention. The method further comprises providing a p-cladding layer, providing an n-cladding layer, providing a first contact arranged on the p-cladding layer and providing a second contact arranged on the n-cladding layer. Preferably the method further comprises providing a first facet and a second facet at opposing side surfaces of the thin-film bonded substrate.

In another aspect of the present invention, a method for manufacturing a light-emitting diode is disclosed, the method comprising the method of manufacturing a thin-film bonded substrate according to the present invention. The method further comprises providing a first contact and providing a second contact. Preferably the method further comprises providing a reflective cavity.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a process flowchart showing a method of manufacturing a thin-film bonded substrate used for semiconductor devices according to an embodiment of the invention; and

FIG. 2 to FIG. 7 are cross-sectional views sequentially showing process steps of the method of manufacturing a thin-film bonded substrate used for semiconductor devices.

### DETAILED DESCRIPTION OF THE INVENTION

Reference will now be made in detail to a method of manufacturing a thin-film bonded substrate used for semiconductor devices according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

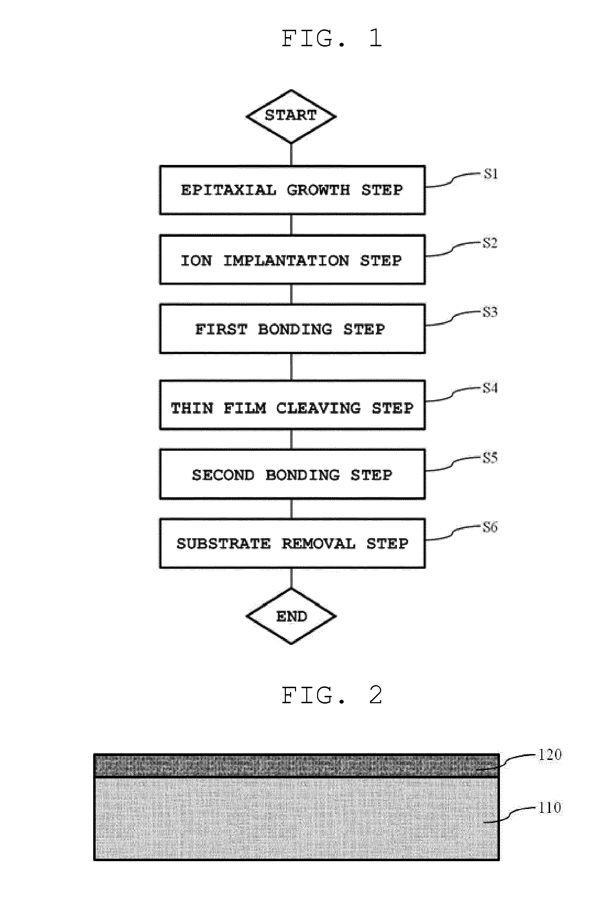

As shown in FIG. 1, the method of manufacturing a thin-film bonded substrate used for semiconductor devices includes an epitaxial growth step S1, an ion implantation step S2, a first bonding step S3, a thin film cleaving step S4, a second bonding step S5 and a substrate removal step S6.

First, as shown in FIG. 2, the epitaxial growth step S1 is a step of growing an epitaxial growth layer 120 on a first substrate 110 of a bulk crystal. Here, the bulk crystal can be made of a nitride semiconductor material, such as a GaN-based nitride semiconductor material that is a group III-V compound. However, according to the present invention, the bulk crystal is not specifically limited to the GaN-based nitride semiconductor material. That is, the bulk crystal can be made of an AIN-based nitride semiconductor material in addition to the GaN-based nitride semiconductor material. In addition, the bulk crystal can be made of one material selected from among candidate materials, such as GaAs, InP and Si, in addition to the nitride semiconductor materials. The bulk crystal can be grown by a predetermined method, such as HVPE or HDC. When the bulk crystal is made of any one of GaN, a GaAs substrate, a sapphire substrate, a SiC substrate and the like can be used as a base substrate, since they have a good lattice match with GaN.

At the epitaxial grown step S1, the epitaxial growth layer 120 is formed by sequentially growing a multiple quantum well (MQW) which acts as an active layer and a p-cladding layer which is made of a GaN-based group III-V nitride semiconductor material. Here, the MQW can be grown, for example, by forming InGaN quantum dots on an InGaN well layer. After the MQW is grown, it is possible to cap the MQW by forming an AIN layer in order to prevent the InGN quantum dots from diffusing to the outside. In addition, a crystal thin film 111, which is separated from the first substrate 110 by the subsequent process will form an n-cladding of a vertical light-emitting device (LED).

The epitaxial grown step S1 can be carried out at a process temperature of about 1000 °C via the MOCVD process. In this fashion, according to this embodiment of the invention, the epitaxial growth process which was carried out as a hot-temperature process after the bonding between a bulk crystal and a heterogeneous substrate in the related art is carried out in advance as a preceding process before a layer transfer process. Therefore, it is possible to fundamentally prevent cracks due to the reaction between the substrates which are bonded to each other or the difference between coefficients of thermal expansion. It is also possible to omit a barrier layer which was formed in order to these problems in the related art, thereby simplifying the process and reducing the manufacturing cost.

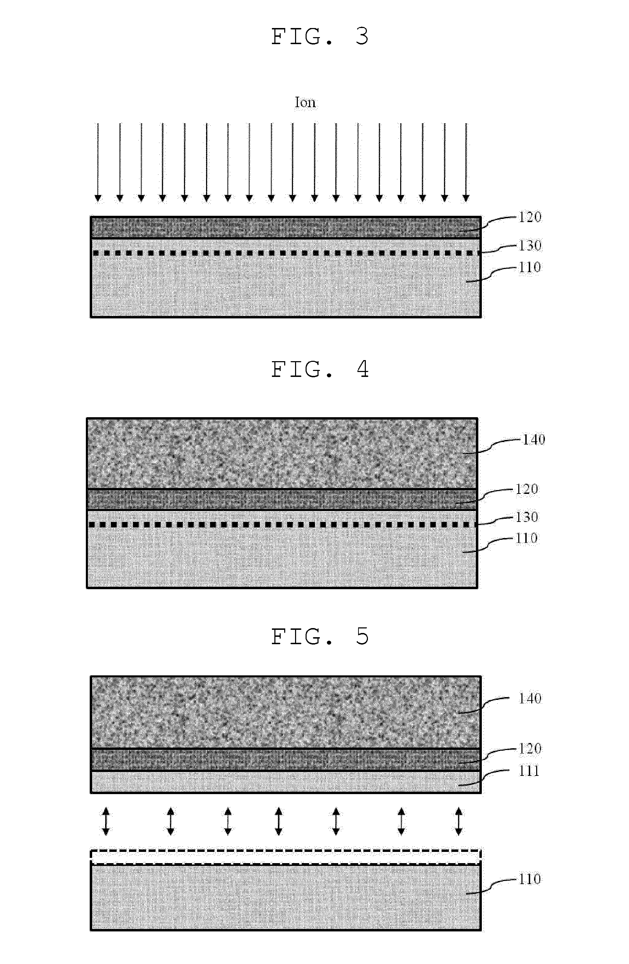

Afterwards, as shown in FIG. 3, the ion implantation step S2 is a step of implanting ions into the first substrate to a predetermined depth from one surface thereof which adjoins one surface of the epitaxial growth layer which is grown on the first substrate at the epitaxial growth step S1, thereby forming an ion implantation layer 130. The ions used at the ion implantation step S2 can be ions of one selected from among hydrogen (H₂), helium (He) and nitrogen (N₂). In this case, it is possible to implant ions to a depth ranging from 0.1 µm to 100 µm from the surface of the first substrate 110, thereby forming the ion implantation layer 130 at that position. The ion implantation layer 130 acts as a boundary surface in a subsequent cleaving process of forming the crystal thin-film 111 having a thickness ranging from 0.1 µm to 100 µm.

The ion implantation step S2 as described above can be carried out using an ion implantation device (not shown).

After that, as shown in FIG. 4, the first bonding step S3 is carried out as a step of bonding a third substrate 140 to the upper surface (with respect to the figure surface) of the epitaxial grown layer 120. Here, the third substrate 140 serves as a support substrate which supports the crystal thin film 111 and the epitaxial growth layer 120 in the subsequent cleaving process.

At the first bonding step S3, the third substrate 140 can be bonded to the epitaxial growth layer 120 via an adhesive. In addition, at the first bonding step S3, the third substrate 140 can be directly bonded to the epitaxial growth layer 120 via heating and pressing, or via various other techniques. Therefore, the bonding technique according to an embodiment of the invention is not limited to a specific technique.

The third substrate 140 is removed from the epitaxial growth layer 120 after the second bonding step S5.

In sequence, as shown in FIG. 5, the thin film cleaving step S4 is a step of cleaving the first substrate along the ion implantation layer 130 formed inside the first substrate 110, thereby leaving the crystal thin film 111 on the underside of the epitaxial growth layer 120, the crystal thin film 111 being separated from the first substrate 110. The crystal thin film 111 will serve as an n-cladding layer of a vertical LED. The thin film cleaving step S4 can include a heat treatment or cutting in order to cleave the first substrate 110. The heat treatment can be available when the ion implantation layer 130 is formed at a relatively shallow position inside the first substrate 110. The heat treatment is an easy technique having superior precision by which the first substrate 110 can be reliably cleaved. When the first substrate 110 and the epitaxial growth layer 120 bonded to each other are heat-treated, the ion implantation layer 130 is embrittled, and the first substrate 110 is cleaved at that position, leaving the crystal thin film 111 on the epitaxial growth layer 120. Here, the temperature of the heat treatment can be adjusted within the range from 300 °C to 600 °C depending on the characteristics of the ions that are implanted. In contrast, the cutting can be available when the ion implantation layer 130 is formed at a relatively deep position. The cutting technique is also an easy technique having superior precision by which the first substrate 110 can be reliably cleaved.

When the first substrate 110 is cleaved via the heat treatment or cutting, the crystal thin film 110 and the epitaxial growth layer 120 are protected from deformation, such as warping, by the third substrate 140 which is bonded to the epitaxial growth layer 120 in order to support the crystal thin film 110 and the epitaxial growth layer 120.

The remaining first substrate 110 from which a portion, i.e. the crystal thin film 111, is separated and reused when forming a crystal thin film of another thin-film bonded substrate. Accordingly, one first substrate 110 can be cleaved into tens to hundreds of crystal thin films 111, and be used for manufacturing tens to hundreds of thin-film bonded substrates 100.

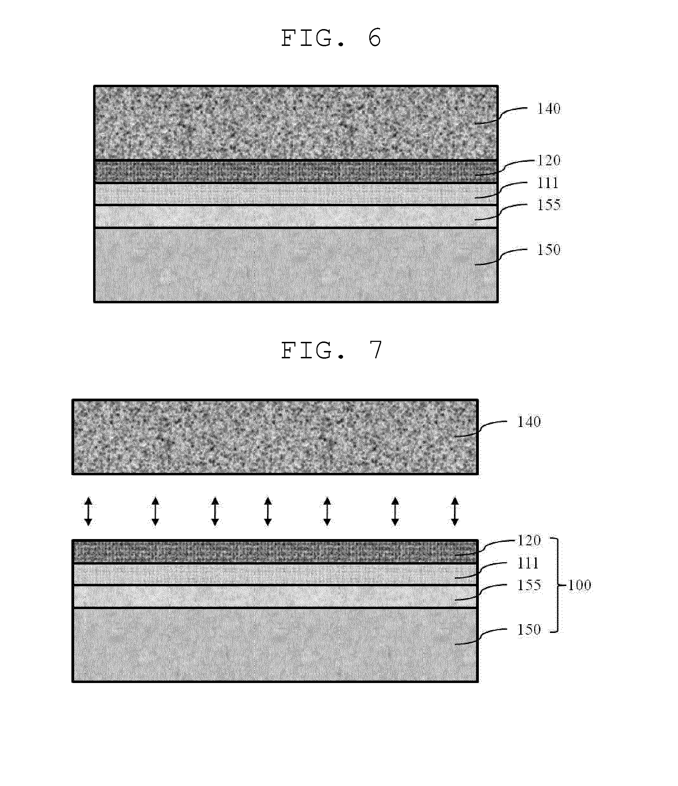

In sequence, as shown in FIG. 6, the second bonding step S5 is a step of bonding a second substrate 150 to the crystal thin film 111, the chemical composition of the second substrate 150 being different from the chemical composition of the first substrate 110. At the second bonding step S5, surface activation or fusion bonding can be used on the premise of uniform low-temperature bonding. The surface activation is a technique of activating the surfaces to be bonded by exposing them to plasma before bonding them to each other, and the fusion bonding is a technique of bonding the surfaces to each other by pressing and heating the surfaces which are cleaned. However, the technique of bonding the second substrate 150 to the crystal thin film 111 according to an embodiment of the invention is not limited to a specific technique, since it is possible to bond the second substrate 150 to the crystal thin film 111 by various other techniques.

At the second bonding step S5, the second substrate 150 can be implemented as a Si substrate.

The second substrate 150 will serve as a base substrate of a vertical LED. Therefore, before the second bonding step S5 is carried out, a reflective layer 155 can be deposited on the bonding surface of the second substrate 150 which is bonded to the crystal thin film 111 in order to enhance light efficiency. Thus, the crystal thin film 111 and the second substrate 150 are bonded to each other via the reflective layer 155.

Since the second bonding step S5 of bonding the heterogeneous materials to each other is carried out after the epitaxial growth step S1 which is carried out as a high-temperature process, it is separately carried out irrespective of the high-temperature process. Accordingly, cracks due to a reaction between the heterogeneous materials or the difference in the coefficients of thermal expansion thereof are fundamentally prevented. In addition, the reflective layer 155 on the second substrate 150 is free from the deterioration of performance at the high temperature processing. Accordingly, it is possible to use an inexpensive metal for the reflective layer 155, thereby reducing the manufacturing cost.

In addition, before the second bonding step S5 is carried out, it is possible to control the maximum surface roughness Rₘₐₓ of the bonding surface, i.e. n-surface of the crystal thin film 111, by polishing the bonding surface and then etching the polished bonding surface in order to enhance the strength of the bonding between the crystal thin film 111 and the second substrate 150. Here, it is preferred that the maximum surface roughness Rₘₐₓ of the bonding surface be 10 µm or less and that the average surface roughness Rₐ of the bonding surface be controlled to be 1 nm or less.

Finally, as shown in FIG. 7, the substrate removal step S6 is a step of removing the third substrate 140 bonded to the upper surface of the epitaxial growth layer 120. Removing the third substrate 140 at the substrate removal step S6 results in the completion of the manufacture of the thin-film bonded substrate 100 for semiconductor devices, in particular, vertical LEDs according to an embodiment of the invention.

Since the thin-film bonded substrate 100 manufactured according to an embodiment of the invention has the epitaxial growth layer 120 for vertical LEDs, it is possible to significantly simplify a fabrication process for vertical LEDs compared to the related art.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A method of manufacturing a thin-film bonded substrate (100) used for a semiconductor device, the method comprising:
epitaxially growing (S1) an epitaxial growth layer (120) on a first substrate (110) of a bulk crystal;
cleaving (S4) the first substrate (110), thereby leaving a crystal thin film (111) on the epitaxial growth layer (120), the crystal thin film (111) being separated out of the first substrate (110); and
bonding (S5) a second substrate (150) to the crystal thin film (111), a chemical composition of the second substrate (150) being different from a chemical composition of the first substrate (110).

2. The method of claim 1, wherein cleaving (S4) the first substrate (110) comprises bonding (S3) a third substrate (140) to the epitaxial growth layer (120) before cleaving the first substrate (110).

3. The method of claim 2, further comprising, after bonding (S5) the second substrate (150) to the crystal thin film (111), removing (S6) the third substrate (140).

4. The method of any of claims 2 and 3, wherein the epitaxial growth layer (120) and the third substrate (140) are bonded to each other via an adhesive.

5. The method of any of claims 2 and 3, wherein the epitaxial growth layer (120) and the third substrate (140) are directly bonded to each other via heating and pressing.

6. The method of any of the preceding claims, wherein forming the crystal thin film comprises:
implanting (S2) ions into the first substrate (110) to a predetermined depth from one surface of the first substrate (110) which adjoins one surface of the epitaxial growth layer (120), thereby forming an ion implantation layer (130) in the first substrate (110);
bonding (S3) a third substrate to the other surface of the epitaxial growth layer (120); and
cleaving (S4) the first substrate (110) along the ion implantation layer (130), thereby leaving the crystal thin film (111) on the one surface of the epitaxial growth layer (120), the crystal thin film (111) being separated out of the first substrate (110).

7. The method of claim 6, wherein implanting (S2) the ions comprises forming the ion implantation layer (130) at a thickness ranging from 0.1 µm to 100 µm from the one surface of the first substrate (110).

8. The method of any of claims 6 and 7, wherein the ions comprise ions of one selected from the group consisting of hydrogen, helium and nitrogen.

9. The method of any of claims 6 to 8, wherein cleaving (S4) the first substrate (110) comprises heat-treating the ion implantation layer (130).

10. The method of any of claims 6 to 8, wherein cleaving (S4) the first substrate (110) comprises cutting the ion implantation layer (130).

11. The method of any of the preceding claims, wherein the crystalline bulk comprises a nitride semiconductor.

12. The method of any of the preceding claims, wherein epitaxially growing (S1) the epitaxial growth layer (120) comprises growing the epitaxial growth layer (120) in a stacked structure which has a multi-quantum well layer and a p-cladding layer stacked on the multi-quantum well layer.

13. The method of claim 12, wherein the p-cladding layer comprises a nitride semiconductor material.

14. The method of any of claims 12 and 13, wherein the crystal thin film (111) comprises an n-cladding layer.

15. The method of any of the preceding claims, further comprising, before bonding (S5) the second substrate (150) to the crystal thin film (111), depositing a reflective layer (155) on one surface of the second substrate (150) to which the crystal thin film (111) is to be bonded.
